## Europäisches Patentamt
## European Patent Office
## Office européen des brevets

(19)

(11) Veröffentlichungsnummer: **0 075 739**
**B1**

(12)

# EUROPÄISCHE PATENTSCHRIFT

(45) Veröffentlichungstag der Patentschrift:
26.11.86

(51) Int. Cl.⁴: **H 01 L 29/60, G 11 C 11/34**

(21) Anmeldenummer: **82108007.4**

(22) Anmeldetag: **31.08.82**

(54) Speicherzelle mit einem Doppel-Gate Feldeffekttransistor und Verfahren zu ihrem Betrieb.

(30) Priorität: **30.09.81 DE 3138947**

(43) Veröffentlichungstag der Anmeldung:
**06.04.83 Patentblatt 83/14**

(45) Bekanntmachung des Hinweises auf die Patenterteilung:
**26.11.86 Patentblatt 86/48**

(84) Benannte Vertragsstaaten:
**AT FR GB IT**

(56) Entgegenhaltungen:
**FR-A-2 235 454**
**GB-A-2 049 279**

**WESCON TECHNICAL PAPERS, Band 16, 19.-22. September 1972, Seiten 1-8, Western Electronic Show and Convention, Los Angeles, California, USA A.C. TICKLE et al.: "Electrically alternable non-volatile semiconductor memory technology" SOLID-STATE ELECTRONICS, Band 24, Nr. 6, June 1981, Seiten 479-483, Pergamon Press Ltd., GB. E.P. JACOBS: "Short channel erase in n-channel Si-gate MNOS EEPROM transistors"**

(73) Patentinhaber: **Siemens Aktiengesellschaft Berlin und München, Wittelsbacherplatz 2, D-8000 München 2 (DE)**

(72) Erfinder: **Jacobs, Erwin, Stieglitzweg 9b, D-8011 Vaterstetten (DE)**

EP 0 075 739 B1

## Beschreibung

Die Erfindung bezieht sich auf eine Speicherzelle nach dem Oberbegriffi des Anspruchs 1 und auf ein Verfahren zu ihrem Betrieb.

Eine Speicherzelle dieser Art ist in der DE - A-29 18 888 ausfülich beschrieben. Die mehrschichtige Gate-Isolierug des Doppel-Gate-Trasistors besteht dabei insbesondere aus einer Tunneloxidschicht (SiO$_2$), einer darüberliegenden Siliziumnitridschicht (Si$_3$N$_4$) und einer diese bedeckenden Oxinitridschicht. Auf dieser befinden sich die beiden Gate-Elektroden in zwei übereinanderliegenden Polysiliziumebenen. Die erste Gate-Elektrode dient dabei als sogenanntes Speichergate, während die zweite Elektrode zum Aufbau von Inversionsschichten an der Grenzfläche des Halbleiterkörpers herangezogen wird, die die Source- und Drain-Gebiete jeweils in Richtung auf die erste Gate-Elektrode verlängern. Ein Transistor mit derartigen Inversionsschichten wird auch als ICT-Transistor (inversion charge transistor) bezeichnet. Die Speicherung einer logischen Information geschieht in der Weise, daß durch eine dem Speichergate zugeführte positive Spannung hinreichender Größe negative Ladungen am der Grenzfläche Nitrid-Oxid bzw. im Nitrid angelagert werden, die die Einsatzspannung des Transistors verschieben. Durch ein als "Kurzkanallöschen" (short channel erase) bezeichnetes Löschverfahren wird die logische Information wieder gelöscht. Beim Auslesen der Speicherzelle wird festgestellt, ob die Einsatzspannung verschoben ist oder nicht. Bei dieser bekannten Speicherzelle ist ein Auswahltransistor vorgesehen, der mit seiner Source-Drain-Strecke das Source-Gebiet des Doppel-Gate-Feldeffekttransistors an die zugeordnete Sourceleitung schaltet. Der Gateanschuß des Auswahltransistors liegt an einer Auswahlleitung (Wortleitung). Dies bedeutet jedoch einen großen Aufwand an Halbleiterfläche für die (selektierbare) Speicherzelle, da sie als sogenannte Zwei-Transistor-Zelle aufgebaut ist.

Der Erfindung liegt die Aufgabe zugrunde, eine Speicherzelle der oben beschriebenen Art anzugeben, die auf einer kleineren Halbleiterfläche realisiert werden kann. Dies wird erfindungsgemäß durch eine Ausbildung nach dem kennzeichnenden Teil des Anspruchs 1 erreicht.

Der mit der Erfindung erzielbare Vorteil besteht insbesondere darin, daß die Auswahl der Speicherzelle über die mit einer Auswahlleitung verbundene zweite Gate-Elektroder erfolgt, so daß der Auswahltransistor der bekannten Speicherzelle entfällt. Eine Gateleitung für die zweite Gate-Elektrode übernimmt also die Funktion einer Auswahlleitung (Wortleitung).

Der Anspruch 2 ist auf einen Halbleiterspeicher mit einer Mehrzahl von Speicherzellen nach Anspruch 1 gerichtet, während der Anspruch 3 ein bevorzugtes Verfahren zum Betrieb einer Speicherzelle nach Anspruch 1 betrifft.

Die Erfindung wird nachfolgend anhand der Zeichnung näher erläutert. Dabei zeigt:

Fig. 1 das Prinzipschaltbild eines aus vier erfindungsgemäß ausgebildeten Speicherzellen bestehenden Speicherfeldes,

Fig. 2 Spannungs-Zeit-Diagramme zur Erläuterug der Betriebsweise einer Speicherzelle nach Fig. 1 und

Fig. 3 ein bevorzugtes Ausfürungsbeispiel eines als Speicherzelle dienenden Doppel-Gate-Transistors.

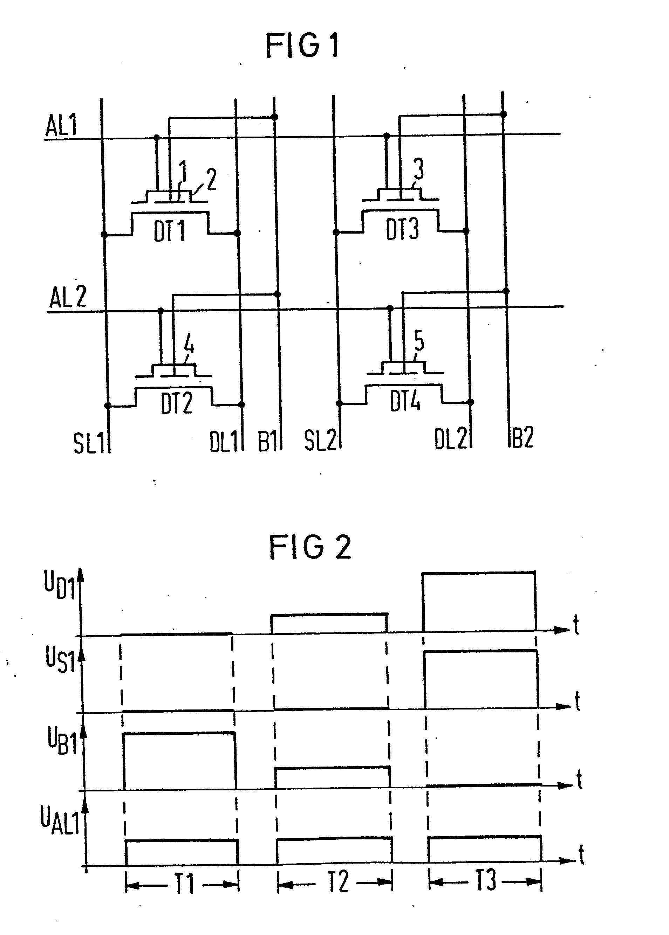

In Fig. 1 ist eine 2x2-Speichermatrix aus vier erfindungsgemäß ausgebildeten Speicherzellen einschließlich der Auswahl- und Ansteuer-Leitungen schematisch dargestellt. Betrachtet man die in der linken Spalte und der oberen Zeile liegende Speicherzelle, die einen Doppel-Gate-Transistor DT1 aufweist, so ist der Sourceanschluß von DT1 mit einer Sourceleitung SL1 verbunden, der Drainanschluß mit einer Drainleitung DL1 und die erste Gate-Elektrode 1 von DT1 mit einer Bitleitung B1. Die entsprechenden Teile des Doppel-Gate-Transistors DT2 der linken unteren Speicherzelle liegen eberfalls an den Leitungen SL1, DL1 und B1. In analoger Weise sind die Sourceanschlüsse der in der rechten Spalte liegenden Doppel-Gate-Transistoren DT3 und DT4 an eine Sourceleitung SL2 geführt, die Drainanschlüsse an eine Drainleitung DL2 und die jeweils ersten Gate-Elektroden an eine Bitleitung B2. Die zweiten Gate-Elektroden 2,3 von DT1 und DT3 liegen an einer gemeinsamen Auswahleitung (Wortleitung) AL1, während die zweiten Gate-Elektroden 4, 5 von DT2 und DT4 mit einer gemeinsamen Auswahlleitung (Wortleitung) AL2 verbunden sind. Die zweiten Gate-Elektroden 2 bis 5 werden im englischen Sprachgebrauch auch als "inversion charge transistor gates" bezeichnet.

Zur Auswahl der Speicherzellen der oberen Zeile wird die Auswahlleitung AL1 mit einer Auswahlspannung von beispielsweise 10 V belegt. Dies führt bei DT1 und DT3 zur Ausbildung von Inversionsschichten unterhalb derjenigen Teile der zweiten Gate-Elektroden, z. B. 2, die außerhalb der ersten Gate-Elektroden, z. B. 1, liegen und die Halbleiterbereiche zwischen diesen letzteren und den zugeordneten Source- und Drain-Gebieten überdecken.

Bei jedem der in der ausgewählten Zeile liegenden Doppel-Gate-Transistoren kann durch eine im folgenden beschriebene Ansteuerung der im zugeordneten Source-, Drain- und Bit-Leitung eine logische Information eingeschrieben, gelesen oder wieder gelöscht werden. Fig. 2 zeigt in übersichtlicher Weise die Zeitverläufe von Spannungen, die einer Speicherzelle, z. B. der linken oberen Speicherzelle von Fig. 1, im Betrieb zuzufüen sind. Im Zeitintervall T1 soll eine logische Information eingeschrieben werden. Dazu liegen die Leitungen DL1 und SL1 auf Bezugspotential und die Bitleitung B1 wird mit einer Programmer-Spannung $U_{B1}$ von z. B. 20 V belegt. Im Zeitabschnitt T2, in dem die eingespeicherte Information gelesen wird, liegt die Sourceleitung SL1 auf Bezugspotential, während die Drainleitung mit einer Drainspannung $U_{D1}$ von z. B. 5 V beschaltet ist und die Bitleitung B1 eine (Lese-) Spannung $U_{B1}$ von z. B. 5 V führt. Das Löschen der eingeschriebenen Information im Zeitabschnitt T3 geht so vor sich, daß die Bitleitung B1 auf Bezugspotential liegt, während über die . Leitungen SL1 und DL1 eine Sourcespannung $U_{S1}$ und eine Drainspannung $D_{D1}$ von jeweils etwa 20 V zugefüht werden, die auch als Löschspannungen bezeichnet werden. In allen Zeitabschmitten T1 bis T3 wird der zweiten Gate-Elektrode 2 des selektierten Doppel-Gate-Transistors DT1 über die Auswahlleitung AL1 eine Auswahlspannung $U_{AL1}$ von etwa 10 V zugeführt.

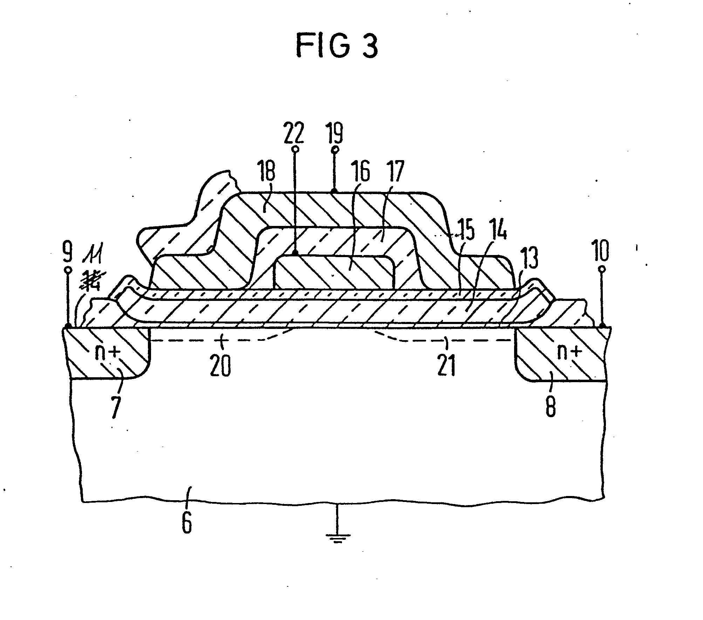

Fig. 3 zeigt einen Doppel-Gate-Transistor nach Fig. 1, z. B. DT1, im Schnitt. In einen auf Bezugspotential liegenden Halbleiterkörper 6 eines ersten Leitungstyps, z. B. aus p-dotiertem Silizium, sind ein n+-dotiertes Sourcegebiet 7 und ein n+-dotiertes Draingebiet 8 eingefügt, die mit Anschlüssen 9 und 10 versehen sind. In dem Bereich zwischen den Gebieten 7 und 8 i st auf der Grenzfläche 11 eine 3 nm dicke Tunneloxidschicht 13 aufgebracht, die von einer Siliziumnitridschicht 14 mit einer Schichtdicke von ca. 40 nm abgedeckt wird. Mit 15 ist eine Oxinitridschicht von etwa 10 nm Dicke bezeichnet. Auf dieser ist eine erste Gate-Elektrode 16 aus polykristallinem Silizium anngeordnet, die durch eine isolierende Zwischenschicht 17 von einer zweiten Gate-Elektrode 18 aus polykristallinem Silizium getrennt ist. Die Gate-Elektrode 18 überdeckt dabei die außerhalb der Gate-Elektrode 16 liegenden, sich bis zu dem Source- und Drain-Gebiet 7 und 8 erstreckenden Teile des Halbleiterkörpers 6. Legt man an den Anschluß 19 der Elektrode 18 eine über der Einsatzspannung liegende Spannung $U_{AL1}$ (Fig. 2) an, so bilden sich Inversionsschichten 20 und 21 aus, die die Gebiete 7 und 8 in Richtung auf das Gate 16 verlängern. Letzteres weist einen Anschluß 22 auf, dem die Spannung $U_{B1}$ (Fig. 2) zugeführt wird.

**Patentansprüche**

1. Speicherzelle mit einem Doppel-Gate-Feldeffekttransistor, der einen dotierten Halbleiterkörper eines ersten Leitungstyps aufweist, in den ein Sourcegebiet und ein Draingebiet eines zweiten Leitungstyps eingefügt sind, der zwei den Halbleiterbereich zwischen diesen Gebieten überdeckende, getrennt ansteuerbare Gate-Elektroden besitzt die in zwei übereinanderliegenden Polysiliziumebenen gebildet sind, wobei die Randzonen der zweiten Gate-Elektrode die außerhalb der ersten Gate-Elektrode liegenden und bis zum Source- und Drain-Gebiet reichenden Teile des Halbleiterbereiches überdecken, und der eine wenigstens die erste Gate-Elektrode (1) vom Halbleiterkörper trennende, Mehrschichten-Gate-Isolierung aufweist, die mit einer die Einsatzspannung verschiebenden elektrischen Ladung beaufschlagbar ist, wobei die zweite Gate-Elektrode Zum Aufbau von Inversionsschichten dient um beim Löschen einer gespeicherten logischen Information einen Kurzkanaleffekt zu erziden dadurch gekennzeichnet, daß die zweite Elektrode (2) mit einer Auswahlleitung (AL1) verbunden ist und als ein das Einschreiben, Lesen oder Kurzkanalöschen von logischen Informationen vorbereitendes Auswahlelement dient.

2. Halbleiterspeicher mit einer Mehrzahl von monolithisch integrierten Speicherzellen nach Anspruch 1, da-durch gekennzeichnet, daß eine Gruppe dieser Speicherzellen (DT1, DT3) jeweils über ihre zweiten Gate-Elektroden (2, 3) mit einer gemeinsamen Auswahlleitung (Wortleitung) (AL1) verbunden sind.

3. Verfahren zum Betrieb einer Speicherzelle nach Anspruch 1, dadurch gekennzeichnet, daß zun Einschreiben einer logischen Information das Source- und das Drain-Gebiet auf Bezugspotential gelegt werden, die erste Gate-Elektrode (1) mit einer Programmierspannung beschaltet wird und der zweiten Gate-Elektrode (2) eine Auswahlspannung $U_{AL1}$ zugeführt wird, daß zum Lesen der eingeschriebenen Information das Sourcegebiet auf Bezugspotential gelegt wird, das Draingebiet mit einer Drainspannung beaufschlagt wird, die erste Gate-Elektrode mit einer Lesespannung beschaltet wird, die den Feldeffekttransistor lediglich im Falle einer nichtverschobenen Einsatzspannung in den leitenden Zustand umschaltet, und der zweiten Gate-Elektrode die Auswahlspannung $U_{AL1}$ zugeführt wird, und daß zum Löschen einer eingeschriebenen logischen Inormation das Source- und Drain-Gebiet jeweils mit einer konstanten Löschspannung belegt werden, die erste Gate-Elektrode auf Bezugspotential gelegt wird und der zweiten Gate-Elektrode die Auswahlspannung ( $U_{AL1}$) zugeführt wird.

**Claims**

1. A storage cell with a double gate field effect transistor which comprises a doped semiconductor body of a first conductivity type into which a source zone and a drain zone of a second conductivity type are introduced, which further comprises two separately operable gate electrodes which cover the semiconductor region between these zones and which are formed in two polysilicon planes arranged one above another, where the edge zones of the second gate electrode cover those parts of the semiconductor region which are located outside the first gate electrode and extend to the source-

5       **0 075 739**       6

and-drain zones, and which further comprises a multi-layer gate insulation which separates at least the first gate electrode (1) from the semiconductor body and which can be acted upon by an electric charge which shifts the start voltage, where the second gate electrode serves to form inversion layers in order to obtain a short-channel effect when a stored item of logic information is erased, <u>characterised</u> in that the second electrode (2) is connected to a selector line (AL1) and serves as a selector element which prepares the write-in, read-out or short-channel erasure of logic information.

2. A semiconductor store with a plurality of monolithically integrated storage cells as claimed in claim 1, <u>characterised</u> in that a group of these storage cells (DT1,DT3) are each connected, via their second gate electrodes (2,3) to a common selector line (word line) (AL1).

3. A method of operating a storage cell as claimed in claim 1, <u>characterised</u> in that in order to write-in an item of logic information, the source-and-drain zones are connected to reference potential, the first gate electrode (1) is connected to a programming voltage and the second gate electrode is supplied with a selector voltage ($U_{AL1}$), that in order to read-out the input information the source zone is connected to reference potential, the drain zone is connected to a drain voltage, the first gate electrode is connected to a read voltage which switches the field effect transistor into the conductive state only when the start voltage is not shifted, and the selector voltage ($U_{AL1}$) is supplied to the second gate electrode, and that in order to erase an input item of logic information the source-and-drain zones are each connected to a constant erasing voltage, the first gate electrode is connected to reference potential and the selector voltage ($U_{AL1}$) is supplied to the second gate electrode.

**Revendications**

1. Cellule de mémoire avec un transistor à effet de champ à double grille comportant un corps semicondcteur dopé d'un premier type de conductivité dans lequel sont insérées une zone de source et une zone de drain d'un second type de conductivité, qui possède deux électrodes de grille qui recouvrent la zone semiconductrice entre ces deux zones, qui sont susceptibles d'être commandées séparément et qui sont formées dans deux plans superposés de polysilicium, les zones marginales de la seconde électrode de grille recouvrant des parties de la zone semiconductrice qui sont situées à l'extérieur de la première électrode de grille et qui s'étendent jusqu'à la zone de source et de drain, et qui possède une isolation multicouche de grille séparant au moins la première électrode de grille (1) du corps semi-conducteur et qui est susceptible de recevoir une charge électrique qui décale la tension de seuil la seconde électrode de grille servant à l'établissement de couches d'inversion afin d'obtenir, à l'effacement d'une information logique, un effet de raccourcissement de canal, caractérisée par le fait que la seconde électrode (2) est reliée à un conducteur de sélection (AL1) et sert d'élément de préparation pour l'inscription, la lecture ou l'effacement par raccourcissement du canal, d'informations logiques.

2. Cellule à semi-conducteur avec plusieurs cellules de mémoire intrégrées monolithiquement selon la revendication 1, caractérisée par le fait qu'un groupe de ces cellules de mémoire (DT1, DT3) est relié, par l'intermédiaire de ses secondes électrodes de grille (2, 3), avec un conducteur de sélection commun (conducteur de mots) (AL1).

3. Procédé pour la mise en oeuvre d'une cellule de mémoire selon la revendication 1, caractérisé par le fait que pour l'inscription d'une information logique, la zone de source et la zone de drain sont portées au potentiel de référence, la première électrode de grille (1) reçoit une tension de programme et la seconde électrode de grille (2) reçoit une tension de sélection ($U_{AL1}$), que pour la lecture de l'information inscrite, la zone de source est portée au potentiel de référence, la zone de drain est portée à une tension de drain, la première électrode de grille reçoit une tension de lecture qui commute le transistor à effet de champ, uniquement dans le cas d'une tension de seuil non décalée, dans son état conducteur, et la tension de sélection ($U_{AL1}$) est appliquée à la seconde électrode de grille, et que pour l'effacement d'une information logique inscrite, la zone de source et la zone de drain reçoivent respectivement une tension constante d'effacement, la première électrode de grille étant portée au potentiel de référence alors que la tension de sélection ($U_{AL1}$) est appliquée à la seconde électrode de grille.

# FIG 1

# FIG 2

# FIG 3